## Europäisches Patentamt

(19) **European Patent Office**

**Office européen des brevets**

(11) Veröffentlichungsnummer: **0 104 534**
**B1**

(12) **EUROPÄISCHE PATENTSCHRIFT**

(45) Veröffentlichungstag der Patentschrift:
06.08.86

(51) Int. Cl.⁴: **G 01 R 31/28**

(21) Anmeldenummer: **83109003.0**

(22) Anmeldetag: **12.09.83**

(54) **Verfahren zur Fehlersuche im Innern von VLSI-Schaltungen mit einer Elektronensonde.**

(30) Priorität: **16.09.82 DE 3234413**

(43) Veröffentlichungstag der Anmeldung:
**04.04.84 Patentblatt 84/14**

(45) Bekanntmachung des Hinweises auf die Patenterteilung:
**06.08.86 Patentblatt 86/32**

(84) Benannte Vertragsstaaten:
**AT DE FR GB IT NL**

(56) Entgegenhaltungen:
**EP - A - 0 014 304**
**DE - A - 2 639 323**
**US - A - 3 942 005**

**ELECTRONICS INTERNATIONAL, Band 55, Nr. 7; April 1982, New York L. LOWE ″Electron beams focus on testing of VLSI″, Seiten 39, 40**
**IEEE JOURNAL OF SOLID STATE CIRCUITS, Band SC 14, Nr. 2, April 1979 E. WOLFGANG et al. ″Electron-beam testing of VLSI circuits″, Seiten 421-481**

(73) Patentinhaber: **Siemens Aktiengesellschaft Berlin und München, Wittelsbacherplatz 2, D-8000 München 2 (DE)**

(72) Erfinder: **Wolfgang, Eckhard, Dr., Winternitzstrasse 6, D-8000 München (DE)**
Erfinder: **Gerner, Manfred, Dipl-Ing., Robert-Koch-Strasse 16, D-8012 Ottobrunn (DE)**
Erfinder: **Grüter, Otto, Dr., Berchemstrasse 17, D-8033 Krailling (DE)**
Erfinder: **Kreisl, Ferdinand, Dipl.-Ing., Gartenstrasse 10c, D-8190 Wolfratshausen (DE)**
Erfinder: **Kessler, Johannes, Englschalkinger Strasse 69, D-8000 München 81 (DE)**

**Beschreibung**

Die Erfindung betrifft ein Verfahren zur Fehlersuche im Innern von VLSI-Schaltungen mit einer Elektronensonde und eine Vorrichtung zur Durchführung eines solchen Verfahrens.

Der Entwurf von VLSI-Schaltungen stützt sich auf eine Vielzahl von CAD-Hilfen, die alle das Ziel haben, dass die integrierten Schaltungen möglichst wenig Fehler aufweisen. Da ein absolut fehlerfreier Entwurf aber in den nächsten Jahren nicht realisierbar erscheint, werden Verfahren benötigt, welche die durch Simulation und Verifikation nicht festgestellten Fehler so rasch wie möglich erkennen und den Fehlerort lokalisieren können.

Aus dem Stand der Technik ist es bekannt, erste Versuchsmuster von VLSI-Schaltungen an einem IC-Tester zu untersuchen und zu charakterisieren. Anhand eines dabei erhaltenen Fehlerbildes des untersuchten Versuchsmusters einer VLSI-Schaltung bemüht man sich, den Fehlerort einzukreisen. Durch Verwendung von mechanischen Spitzen und/oder einer Elektronensonde kann sodann die Feindiagnose eines Fehlers erfolgen. Die Erfahrung hat jedoch gezeigt, dass eine solche Vorgehensweise bei VLSI-Schaltungen nicht immer in der Lage ist, einen Fehler zu erkennen und zu lokalisieren, da der Soll-/Ist-Vergleich von sehr vielen internen Knoten visuell bzw. manuell nicht mehr durchführbar ist.

Aus «Electronics International», Band 55, Nr. 7; April 1982, Seiten 39, 40, ist ein Verfahren zur Fehlersuche im Innern von VLSI-Schaltungen mit einer Elektronensonde nach dem Oberbegriff des Anspruchs 1 bekannt. Diese bereits bekannte Methode der internen Prüfung mit Hilfe der Elektronenstrahl-Messtechnik stellt die Soll-Werte, die mit einem Logiksimulator berechnet wurden, für den Soll-/Ist-Vergleich zur Verfügung. Für das Testen von VLSI-Schaltungen ist jedoch eine Strategie zur Durchführung einer Fehlersuche erforderlich. Um den Soll-/Ist-Vergleich durchführen zu können, muss das Fehlerbild, welches sich am IC-Tester zeigt, am Spitzenmessplatz oder am Elektronenstrahl-Messgerät nachgebildet werden. Dies ist jedoch mit denjenigen IC-Ansteuerungen nicht möglich, welche für Einzelmessungen an internen Knoten Verwendung finden und die in der Regel aus Puls- und Wortgeneratoren bestehen.

Ein Fehler-Analysiersystem zur automatischen Bestimmung des Fehlerortes auf einer gedruckten Schaltungsplatine ist aus der deutschen Offenlegungsschrift 2639323 bekannt. In diesem Analysiersystem wird die zu untersuchende Platine mit geeigneten Testsignalen angesteuert und festgestellt, ob an deren Ausgangsklemmen die erwarteten Spannungen anliegen. In Platinen mit einem gestörten Ausgang erfolgt die Lokalisierung des Fehlers dann durch Messung des Signalpegels an allen Knotenpunkten innerhalb der Schaltung, die mit dieser Ausgangsklemme leitend verbunden sind. Die Messung der Signalpegel erfolgt mit Hilfe einer mechanischen Tasteinrichtung, die rechnergesteuert auf jeden Punkt des von der gestörten Ausgangsklemme bis zu einem Anschlusspunkt innerhalb des Schaltkreises reichenden Fehlerweges positioniert werden kann.

Der vorliegenden Erfindung liegt die Aufgabe zugrunde, ein Verfahren der eingangs genannten Art anzugeben, welches einen Fehler innerhalb einer VLSI-Schaltung automatisch erkennen und den Fehlerort lokalisieren kann.

Diese Aufgabe wird erfindungsgemäss durch ein Verfahren nach dem Anspruch 1 gelöst. Ausgestaltungen und Vorteile der Erfindung sind in den Unteransprüchen, der Beschreibung und der Zeichnung dargestellt.

Besonders vorteilhaft bei der Ermittlung eines Fehlerpfades ist die Verwendung eines Testalgorithmus, der bei der Ermittlung des Fehlerpfades bestimmte Prüfpunkte in einer bestimmten Reihenfolge festlegt.

Ähnlich wie bei einem Verfahren nach der US-PS 4277679 erfolgt vorteilhafterweise die Bewertung der Schaltungszustände an den Prüfpunkten so, dass zuerst eine Referenzspannung ermittelt wird, auf welche die ermittelten Spannungswerte bezogen werden.

Vorteilhafterweise wird die Elektronensonde automatisch auf den jeweils zu untersuchenden Prüfpunkt innerhalb der VLSI-Schaltung positioniert. Dabei kann die Lehre der US-PS 3942005 Verwendung finden.

Vorteilhafterweise werden für eine Erkennung dynamischer Fehler im Rahmen der erfindungsgemässen Teststrategie zusätzlich zyklische Prüfschleifen on-line am Testrechner erstellt.

Vorteilhafterweise kommen mehr als ein Prüfmuster innerhalb eines Prüfprogramms zur Anwendung. Dabei kann es vorteilhaft sein, dass während des Ablaufs von mehr als einem Prüfmuster die Prüfsonde (Elektronensonde) auf einem einzigen Prüfpunkt verharrt und den jeweiligen Ist-Wert für das jeweilige Prüfmuster an eben diesem Prüfpunkt erstellt. Bei logisch einander benachbarten Prüfpunkten kann es weiter von Vorteil sein, dass während des Ablaufs eines einzigen Prüfmusters die Prüfsonde den jeweiligen Ist-Wert an verschiedenen Prüfpunkten ermittelt.

Eine Vorrichtung zur Durchführung eines erfindungsgemässen Verfahrens weist vorteilhafterweise je eine Datei für ein Prüfprogramm für die Koordinaten der Prüfpunkte und für eine Liste der Soll-Werte an den Prüfpunkten auf.

Zur raschen und sicheren Positionierung der Elektronensonde auf den jeweiligen Prüfpunkt sind bei einer Vorrichtung zur Durchführung eines erfindungsgemässen Verfahrens vorteilhafterweise im Innern der VLSI-Schaltung mit Namen versehene Prüfflecken vorgesehen, deren Koordinaten als Koordinaten der Prüfpunkte in einer Datei abgelegt sind.

Die Erfindung ermöglicht das automatische Erkennen logischer Fehler innerhalb von VLSI-Schaltungen, weil ein IC-Tester um die Möglichkeit einer automatischen Fehlersuche an internen Prüfpunkten erweitert worden ist. Dazu kommt erfindungsgemäss eine Teststrategie, welche sich an das bekannte Verfahren der Fehlerpfad-Verfolgung (Störungspfad-Verfolgung; fault path tracing method) anlehnt, welches für das Testen von Flachbaugruppen-Prototypen entwickelt worden ist (F. Kreisl et al: Fehlerdiagnosesystem für komplexe Logikbaugruppen, Arbeitsbericht an das Bundesministerium für Forschung und Technologie, BMFT-FB DV 79–10, Dezember 1979, ISSN 0170 9011, Verkauf durch: Fachinformationszentrum Energie, Physik, Mathematik GmbH, Kernforschungszentrum, D-7514 Eggenstein-Leopoldshafen 2).

Die Erfindung ermöglicht eine rasche Feststellung, welche Funktionsblöcke einer VLSI-Schaltung einwandfrei arbeiten. Durch Einsatz der automatischen Fehlersuche ermöglicht die Erfindung eine schnelle Bestimmung der Grenze zwischen fehlerhaftem und fehlerfreiem Gebiet innerhalb einer VLSI-Schaltung sowie eine Bestimmung, welche Operationen von der VLSI-Schaltung ausgeführt werden können und welche nicht. Weiterhin ermöglicht die Erfindung, dass das Testergebnis z.B. in Form einer «Fehlerkarte» (failure map) dargestellt wird, wobei Fehlermeldungen zu internen Prüfpunkten wahlweise ausgegeben werden können. Die automatische Fehlersuche im Innern der VLSI-Schaltung erfolgt mit dem Prüfprogramm, welches auch für das Testen über die externen Anschlüsse verwendet wird und mit denjenigen Prüfmustern, mit denen die Logiksimulation erfolgte. Die Prüfgeschwindigkeit mit der Elektronensonde im Einzelschritt (single step mode) beträgt etwa 1 kHz. Die zyklischen Prüfschleifen für die Erkennung dynamischer Fehler durch Messung von zeitabhängigen Vorgängen müssen dann nur für bestimmte Fälle on-line, d.h. am Tester, erstellt werden. Bei Durchführung einer Prüfung in Einzelschritten ermöglicht die Erfindung eine automatische Fehlersuche, wie sie bei der Flachbaugruppen-Prüfung angewendet wird. Erfindungsgemäss wird eine Fehlerpfad-Verfolgung (guided probe) angewandt, die an einem Ausgang der VLSI-Schaltung beginnt und entlang eines Fehlerpfades in die VLSI-Schaltung hinein bis zu einem fehlerfreien Prüfpunkt verläuft. Zur Durchführung eines solchen Verfahrens werden erfindungsgemäss die durch Prüfpunkte auf der VLSI-Schaltung separierten Schaltungsteile als «quasi-Bausteine» in eine Datei (Bibliothek) aufgenommen, wird der Fehlerpfad-Verfolgungsalgorithmus diesem speziellen Verfahren angepasst und wird eine Nahtstelle (Beispiel: IEC-Bus) zur Steuerung des Elektronenstrahl-Messgerätes realisiert.

Ausführungsbeispiele der Erfindung werden anhand der Zeichnung im folgenden näher beschrieben.

Fig. 1 zeigt eine Vorrichtung zur Durchführung eines erfindungsgemässen Verfahrens;

Fig. 2 und 3 zeigen Beispiele für eine Fehlerpfad-Verfolgung.

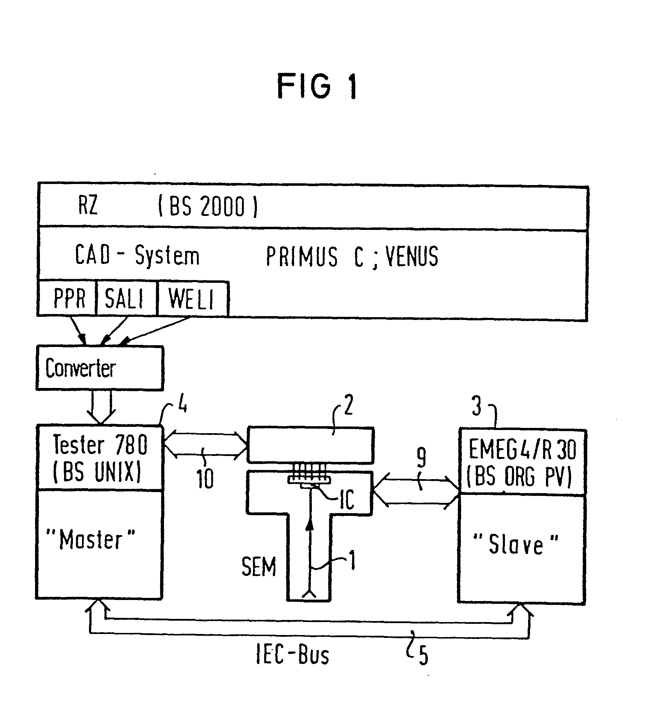

Für eine Vorrichtung zur Durchführung eines erfindungsgemässen Verfahrens nach Fig. 1 kann ein modifiziertes Raster-Elektronenmikroskop SEM zusammen mit einem Elektronenstrahl-Messgerät 3 und den zugehörigen Ansteuerungen 9 verwendet werden, wie sie beispielsweise in der US-Patentschrift 4277679 oder in der Veröffentlichung von P. Fazekas et al in «Electronics», Vol. 54, No. 14, 105–112 (1981) beschrieben sind. Die Elektronensonde (Prüfsonde) 1 löst an einem Prüfpunkt innerhalb der zu prüfenden integrierten Schaltung IC Sekundärelektronen aus, deren Sekundärelektronen-Messignal die Unterscheidung logischer Zustände mit Hilfe des Potentialkontrastes ermöglicht. Zur sicheren Bewertung dieser logischen Zustände wird ein entsprechender Diskriminator verwendet. Der Soll-/Ist-Wertevergleich findet im Prozessrechner R30 (Hersteller: Siemens) des Elektronenstrahl-Messgerätes 3 statt. Die Verbindung («connection») 9 umfasst eine Ansteuerung des Strahlaustastsystems des Raster-Elektronenmikroskops SEM und eine Diskriminatorschaltung zur sicheren logischen Bewertung der Sekundärelektronen-Messignale.

Der Testkopf 2 dient zur Ansteuerung der zu prüfenden integrierten Schaltung IC. Die Verwendung eines Testkopfes 2 ist dem Fachmann von der Prüfung eines integrierten Schaltkreises mit Hilfe eines Logikanalysators her bekannt. Dieser Testkopf 2 wird seinerseits über eine Ansteuerung 10 vom Tester 4 gesteuert. Der Tester 4 steuert die automatische Fehlersuche. Für den Tester 4 kann beispielsweise ein Tester 764 oder 780 (Hersteller: jeweils Siemens) mit einem Betriebssystem UNIX (das Betriebssystem UNIX wurde von der Fa. Bell entwickelt) Verwendung finden. Der Tester 4 synchronisiert die Ansteuerung der zu prüfenden integrierten Schaltung IC und der Strahlaustastung der Elektronensonde 1 über die Ansteuerung 10 und über den IEC-Bus 5. Der Tester 4 fungiert als «Master» und das Elektronenstrahl-Messgerät 3 fungiert als «Slave». Der Tester 4 übermittelt dem Elektronenstrahl-Messgerät 3 die Befehle für die jeweilige räumliche und zeitliche Positionierung der Elektronensonde 1 und die jeweiligen Soll-Werte für die jeweils zu untersuchenden Prüfpunkte. Das Elektronenstrahl-Messgerät 3 übermittelt dem Tester 4 das Ergebnis der Soll-/Ist-Wertvergleiche. Mit Hilfe eines CAD (computer aided design)-Systems VENUS bzw. PRIMUS C (beide Systeme sind von Siemens erhältlich) werden drei Dateien erzeugt, nämlich Prüfprogramm «PPR» mit Schaltungsliste «SALI» (Siemens-Dateiname) und Werteliste «WELI» (diese Werteliste enthält die Soll-Werte der Prüfpunkte in Abhängigkeit von den über den Testkopf 2 an die integrierte Schaltung IC angelegten Eingangs-Testsignalen; auch die Programme zur Erstellung dieser Werteliste «WELI» sind von Siemens erhältlich), die mit folgenden Elementen über einen Konverter im Tester 4 abgelegt werden: Koordinaten der Prüfpunkte (im Ausführungsbeispiel mit Hilfe der Schaltungsliste «SALI»), Soll-Werte an den Prüfpunkten (im Ausführungsbeispiel über die Werteliste «WELI»), Störungspfad-Testalgorithmus (im Ausführungsbeispiel kann dafür die Datei «SALI» oder eine weitere Datei «ARIADNE» verwendet werden), zeitliche und räumliche Ansteuerung von Prüfpunkten («PPR»), Prüfschleifengenerierung (on-line). Die in Anführungszeichen stehenden Namen sind Datei-Namen des in der obengenannten Veröffentlichung von F. Kreisl et al näher beschriebenen PALOG-Systems für die Fehlerpfad-Verfolgung bei der Flachbaugruppen(printed circuit boards)-Prüfung. Diese Dateien können beispielsweise in einem Siemens-BS 2000-Rechenzentrum RZ mit den Programmen bzw. Dateien HKP, INZU, AKTI, GESIWE erstellt werden.

Die Schaltungsliste «SALI» besitzt die Informationen über die Koordinaten der internen Prüfpunkte der zu prüfenden integrierten Schaltung IC und die Informationen um logische Abhängigkeiten der Prüfpunkte zueinander. Die Werteliste «WELI» enthält eine Selektion von Soll-Pegeln der internen Prüfpunkte. Das allgemeine Prüfprogramm «PPR» umfasst etwa $10^3-10^4$ Prüfschritte bzw. Informationen. Schaltungsliste und Werteliste sind Voraussetzung für ein automatisches Fehlersuch-Verfahren. Das Elektronenstrahl-Messgerät 3 wird im Betriebssystem «BS ORG PV» (dieses Betriebssystem ist von Siemens erhältlich) betrieben.

Im Innern der Schaltung IC sind Prüfflecken vorgesehen, die einen Namen bekommen, deren Koordinaten (Prüffleckmitte) in einer Datei «SALI» abgelegt werden und deren logische Verknüpfungen untereinander bestimmt werden. Die Funktion der VLSI-Schaltung IC wird mit einem Logik-Simulator CAD-System «VENUS» bzw. «PRIMUS C» simuliert und die Soll-Pegel, die bei bestimmten Prüfmustern zu erwarten sind, in einer Werteliste («WELI») abgelegt. Die VLSI-Schaltung IC wird über die externen Anschlüsse mit Hilfe des Testers 4 und des Testkopfes 2 getestet. Das sich aus diesem Test ergebende Fehlerbild dient der automatischen Fehlersuche für die Festlegung des ersten Prüfmusters im Fehlerpfad. Die Elektronensonde 1 wird auf den ersten Prüfpunkt positioniert, das entsprechende Prüfmuster wird über den Testkopf an die integrierte Schaltung IC angelegt und mit Hilfe des Potentialkontrastes wird vom Elektronenstrahl-Messgerät 3 der Ist-Wert an diesem ersten Prüfpunkt bestimmt. Nachdem vom Prozessrechner R30 der Soll-/Ist-Wertevergleich für diesen ersten Prüfpunkt durchgeführt worden ist, wird vom Tester 4 das Testen des nächsten Prüfpunktes im Fehlerpfad veranlasst. Dieser Vorgang wird auf Veranlassung des Testers 4 solange wiederholt, bis der Fehlerort in der integrierten Schaltung IC lokalisiert und die Fehlerursachen bestimmt sind. Ein Prüfpunkt im Sinne dieser Erfindung ist ein metallisches Stück innerhalb einer VLSI-Schaltung oder irgendein Punkt, an dem eine zu ermittelnde Spannung anliegt.

Die zu prüfende integrierte Schaltung IC kann mit Hilfe eines Tisches positioniert werden. Eine Steuerung dieses Tisches kann ebenfalls über die Verbindung 9 erfolgen. Eine Temperaturstabilisierung eines solchen Tisches erfolgt in bekannter Weise über ein Gebläse, welches bei Bedarf die integrierte Schaltung IC kühlt.

Über die Ansteuerung 10 werden auch sogenannte «READY»-Signale vom Testkopf 2 an den Tester 4 abgegeben. Diese sogenannten «READY»-Signale umfassen beispielsweise Signale, die die richtige Positionierung des Tisches, auf dem sich die integrierte Schaltung IC befindet, oder eine sonstige Bereitschaft zur Ausführung weiterer im Prüfablauf notwendiger Schritte oder auch Alarm melden.

Bei der Fehlerpfad-Verfolgung wird entlang eines Signalweges (Fehlerpfad) eine von einem Fehlerort ausgehende Störung bis zu diesem Fehlerort zurückverfolgt. Zur Durchführung der Fehlerpfad-Verfolgung werden eine Beschreibung der Schaltung und eine Liste von Soll-Werten für Prüfpunkte benötigt. Wird beim Vergleich eines gemessenen Ist-Wertes für das elektrische Potential an einem Prüfpunkt mit dem zugehörigen Soll-Wert ein Fehler festgestellt, so wird mit Hilfe einer Prüfstrategie ein erster zu untersuchender Prüfpunkt festgestellt. Die an diesem ersten zu untersuchenden Prüfpunkt gemessenen Ist-Werte werden mit den zugehörigen Soll-Werten verglichen. Aus dem Vergleichsergebnis (Richtig/Falsch) und mit Hilfe der Schaltungsliste wird gemäss einer zugrundegelegten Prüfstrategie der nächste zu untersuchende Prüfpunkt festgelegt.

Bei der Fehlerpfad-Verfolgung sind folgende Merkmale verwirklicht: Als erster zu untersuchender Prüfpunkt wird im Normalfall diejenige Ausgangsleitung eines Quasi-Bausteines ausgewählt, der einen gestörten elektrischen Ausgang der zu untersuchenden integrierten Schaltung IC speist. Wird eine Gruppe von gestörten elektrischen Ausgängen der zu untersuchenden integrierten Schaltung IC festgestellt, so kann bei einer ersten Vorgehensweise als erster zu untersuchender Prüfpunkt diejenige Ausgangsleitung eines Quasi-Bausteines ausgewählt werden, die den ersten elektrischen Ausgang dieser Gruppe von gestörten elektrischen Ausgängen der zu untersuchenden integrierten Schaltung IC speist. Alternativ dazu kann aber in einer zweiten Vorgehensweise der erste zu untersuchende Prüfpunkt nach der «Schnittpunktmethode» ermittelt werden. Dabei wird mit Hilfe der Schaltungsliste ein interner Prüfpunkt (elektrischer Ausgang eines Bausteines) ermittelt, von dem aus Signalwege zu allen gestörten elektrischen Ausgängen der zu untersuchenden integrierten Schaltung IC hinführen. Für den Fall, dass der nach dieser «Schnittpunktmethode» ermittelte erste zu untersuchende Prüfpunkt ungestört ist, wird bei dieser Vorgehensweise der Fehlerpfad-Verfolgung als zweiter zu untersuchender Prüfpunkt derjenige gestörte elektrische Ausgang der integrierten Schaltung IC ermittelt, der am tiefsten in die integrierte Schaltung IC hineinreicht.

Die Störungspfad-Verfolgung ist so angelegt, dass möglichst wenige interne Prüfpunkte untersucht werden müssen. Dadurch ist die Dauer der Fehlersuche so kurz wie möglich. Damit die Anzahl der zu untersuchenden Prüfpunkte klein bleibt, wird der Fehlerpfad, soweit dies möglich ist, bereits an einem internen Prüfpunkt begonnen und nicht an einem elektrischen Ausgang der zu untersuchenden integrierten Schaltung IC. Zudem werden bis zum Erreichen des Fehlerpfad-Endes nur Quasi-Baustein-Eingänge untersucht, und zwar nur solche Eingänge von Quasi-Bausteinen, von denen Signalwege durch diesen Quasi-Baustein hindurch zu demjenigen Ausgang dieses Quasi-Bausteines hinführen, über den der Fehlerpfad diesen Quasi-Baustein erreicht hat.

Die Prüfmusterfolge, bei der die Störung auftritt, läuft bei jedem zu untersuchenden Prüfpunkt von Anfang an und stets nur bis zur frühesten Fehlermeldung, die entweder von einem elektrischen Ausgang der integrierten Schaltung IC oder von dem zu untersuchenden Prüfpunkt kommen kann. Die früheste Fehlermeldung kann sich von einem zu untersuchenden Prüfpunkt zu den darauffolgenden zu untersuchenden Prüfpunkten mit dem Fortschreiten der Fehlerpfad-Verfolgung längs des Fehlerpfades nur zu früheren Prüfmustern hin verschieben.

Diese Vorgehensweise verhindert in den meisten Fällen, dass der Fehlerpfad in eine Schleife läuft. Sollte der Fehlerpfad dennoch in eine Schleife laufen, d. h. wieder zu einem schon früher abgeprüften Quasi-Baustein zurückführen, so wird mit Hilfe der Prüfstrategie eine solche Situation erkannt. In einer solchen Situation können alle beim ersten Durchgang nicht untersuchten Eingänge aller Quasi-Bausteine, die in der Schleife enthalten sind, geprüft werden. Findet sich unter diesen Eingängen ein gestörter Eingang, so kann der Fehlerpfad von diesem gestörten Eingang aus weiterverfolgt werden. Sind dagegen alle diese Eingänge all dieser Quasi-Bausteine, die in dieser Schleife enthalten sind, ungestört, so kann der Fehler innerhalb dieser Schleife nicht genauer lokalisiert werden. In einem solchen Fall muss der Fehler mit anderen Mitteln eingegrenzt werden, z. B. durch Prüfung der in der Schleife enthaltenen Quasi-Bausteine auf richtige logische Funktion.

Der Fehlerpfad endet, wenn an einem Quasi-Baustein, zu dem der Fehlerpfad geführt hat, alle Eingänge ungestört sind. Als letzter Prüfpunkt des Fehlerpfades wird dann der zugehörige Ausgang dieses Quasi-Bausteines untersucht.

Die Schaltungsliste «SALI» ist eine Beschreibung der integrierten Schaltung IC, die es ermöglicht, Signalwege entgegen der Signalflussrichtung auf einfache Weise per Programm zu verfolgen.

Die Werteliste «WELI» enthält für alle Prüfschritte und alle internen Prüfpunkte die logischen Soll-Werte. Diese Soll-Werte werden im allgemeinen aus den vorgegebenen Eingangsprüfmusterfolgen durch Simulation der integrierten Schaltung IC errechnet.

Der Fehlerpfad-Testalgorithmus «ARIADNE» ermittelt aus dem jeweiligen Messergebnis (Richtig/Falsch) an dem jeweils zuletzt untersuchten internen Prüfpunkt mit Hilfe der Schaltungsliste «SALI» den nächsten zu untersuchenden Prüfpunkt, holt die Soll-Werte für diesen nächsten zu untersuchenden Prüfpunkt aus der Werteliste «WELI» und lädt diese Soll-Werte in den Speicher des Rechners R30. Dieser Fehlerpfad-Testalgorithmus «ARIADNE» ist wie das gesamte Prüfautomaten-Betriebssystem in «COLUMBUS-Assembler» geschrieben.

Alle Quasi-Bausteine, die in zu untersuchenden integrierten Schaltkreisen IC vorkommen, müssen in eine Quasi-Baustein-Bibliothek aufgenommen werden. Eine solche Bibliothek enthält im wesentlichen Angaben über die Verknüpfung von Ein- und Ausgängen durch Signalwege im Innern des jeweiligen Quasi-Bausteines.

Ein- und Ausgänge eines jeden Quasi-Bausteines sind je einem Prüfpunkt zugeordnet, dessen Koordinaten in der Schaltungsliste «SALI» abgelegt sind. Ebenso sind die Koordinaten der Ausgänge der integrierten Schaltung IC in dieser Schaltungsliste «SALI» festgehalten. Zu jedem Eingang eines jeden Quasi-Bausteines und zu jedem Ausgang der integrierten Schaltung IC ist der Satz derjenigen Ausgänge von anderen Quasi-Bausteinen in der Schaltungsliste «SALI» angegeben, der diesen Quasi-Baustein-Eingang bzw. -Ausgang der integrierten Schaltung IC speist.

Falls der den letzten gestörten internen Prüfpunkt speisende Sender (elektrischer Ausgang eines Quasi-Bausteines) ungestört ist, der Empfänger (elektrischer Eingang eines Quasi-Bausteines) dagegen gestört ist, liegt wahrscheinlich eine Leitungsunterbrechung vor.

Falls Sender und Empfänger am letzten gestörten internen Prüfpunkt gestört sind, kann aus dem vorliegenden falschen Messpegel in manchen Fällen auf den zugrundeliegenden Fehler geschlossen werden, z.B. auf einen Kurzschluss gegen eine Versorgungsspannung.

Falls an dem letzten gestörten internen Prüfpunkt des Fehlerpfades Signalwechsel stattfinden, kann durch Vergleich der Wertefolge an diesem letzten gestörten internen Prüfpunkt mit den Soll-Wertefolgen anderer Punkte auf einen möglichen Kurzschluss zu einem anderen Punkt hingewiesen werden.

Im allgemeinen verbindet ein interner Prüfpunkt nicht einen einzigen Sender mit einem einzigen Empfänger. Häufig sind mehrere Sender und mehrere Empfänger angeschlossen, z. B. über einen Datenbus. Mit Hilfe der Schaltungsliste «SALI» können alle an einen Prüfpunkt angeschlossenen Sender und Empfänger ermittelt werden. Gestörte Sender an einem Prüfpunkt können z. B. dadurch ermittelt werden, dass Sender, die einen bestimmten Prüfpunkt speisen, zeitlich nacheinander, jeder in einem für ihn charakteristischen Prüfschritt senden. Analog können die angeschlossenen Empfänger geprüft werden, indem jeder Empfänger in einem für ihn charakteristischen Prüfschritt geöffnet wird. So weist eine Störung in einem bestimmten Prüfschritt auf eine Störung in einem bestimmten Sender oder in einem bestimmten Empfänger hin.

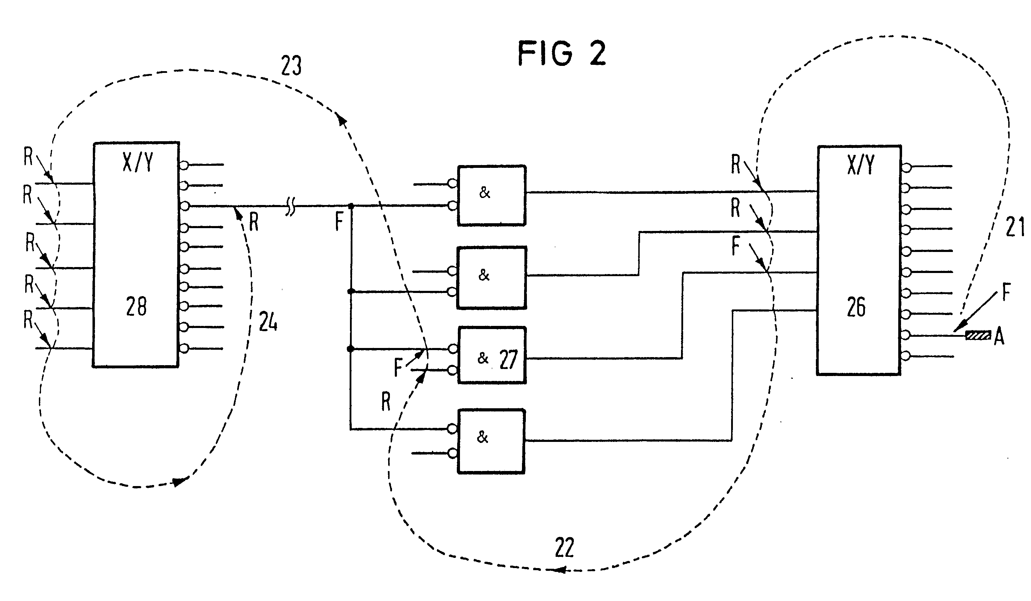

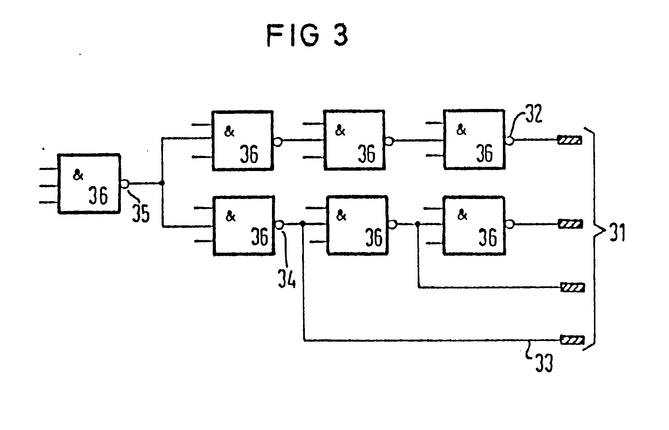

Die Fig. 2 und 3 zeigen zwei Beispiele für Vorgehensweisen bei einer Fehlerpfad-Verfolgung. In der Fig. 2 ist ein gestörter Ausgang A der zu untersuchenden integrierten Schaltung IC angegeben. Zuerst wird ermittelt, dass dieser gestörte Ausgang A von einem Ausgang des Quasi-Bausteines 26 gespeist wird. In einem nächsten Schritt 21 werden sämtliche Eingänge dieses Quasi-Bausteines 26 ermittelt und geprüft. Wird dabei ein gestörter Eingang dieses Quasi-Bausteines 26 festgestellt, so wird derjenige Baustein 27 ermittelt, dessen Ausgang diesen gestörten Eingang des Quasi-Bausteines 26 speist. In einem weiteren Prüfschritt 22 werden die Eingänge des Quasi-Bausteines 27 ermittelt und überprüft. Wird dabei wiederum ein gestörter Eingang dieses Quasi-Bausteines 27 festgestellt, so wird ermittelt, dass ein Ausgang des Quasi-Bausteines 28 diesen gestörten Eingang des Quasi-Bausteines 27 speist. In einem weiteren Prüfschritt 23 werden nunmehr die Eingänge dieses Quasi-Bausteines 28 ermittelt und überprüft. Da in dem Beispiel von Fig. 2 sämtliche Eingänge des Quasi-Bausteines 28 ungestört sind, wird in einem weiteren Prüfschritt 24 derjenige Ausgang des Quasi-Bausteines 28 ermittelt und überprüft, der zum gestörten Eingang des Quasi-Bausteines 27 führt. Da dieser Ausgang des Quasi-Bausteines 28 sich in dem Beispiel von Fig. 2 als ungestört erweist, so wird als letzter gestörter interner Prüfpunkt der gestörte Eingang des Quasi-Bausteines 27 festgestellt. Also muss zwischen dem gestörten Eingang des Quasi-Bausteines 27 und dem ungestörten zugehörigen Ausgang des Quasi-Bausteines 28 eine Leitungsunterbrechung vorliegen. Gestörte Punkte sind in der Zeichnung mit F bezeichnet, ungestörte Punkte sind mit R angegeben.

Fig. 3 zeigt eine weitere Vorgehensweise bei einer Fehlerpfad-Verfolgung. Eine Gruppe 31 von Ausgängen der zu untersuchenden integrierten Schaltung IC seien gestört. Im Normalfall wäre der Prüfpunkt 32 der erste zu untersuchende Prüfpunkt. Da jedoch alle Ausgänge der Gruppe 31 von Ausgängen der integrierten Schaltung IC den internen Prüfpunkt 35 als gemeinsamen Vorläufer haben, wird alternativ zum Normalfall hier der Prüfpunkt 35 als erster zu untersuchender Prüfpunkt nach der «Schnittpunktmethode» ausgewählt. Falls dieser Prüfpunkt 35 sich als ungestört erweist, wird der Prüfpunkt 34 als nächster zu untersuchender Prüfpunkt ausgewählt, weil dieser Prüfpunkt 34 derjenige Ausgang eines Quasi-Bausteines 36 ist, der unmittelbar den Ausgang 33 der integrierten Schaltung IC speist, wobei dieser Ausgang 33 unter allen Ausgängen der Gruppe 31 von Ausgängen der integrierten Schaltung IC am tiefsten in die integrierte Schaltung IC hineinreicht.

Wenn eine integrierte Schaltung IC aus Zellenbausteinen zusammengesetzt worden ist, dann können diese Zellenbausteine als Quasi-Bausteine im Sinne dieser Erfindung betrachtet werden. Für Zellenbausteine liegen in sogenannten Zellenbibliotheken (Siemens-CAD-Design-Center) fertig entworfene, rechteckige Zellen (Standard- und allgemeine Zellen) mit vorgegebenem Funktionsumfang (z.B. 2-NAND, FLIP-FLOP) vor. Für die Prüfdaten-Ermittlung werden zur Fehlererkennung Prüfbitmuster generiert. Das Generatorprogramm zur Generierung der Prüfbitmuster wird mit der Schaltungsbeschreibung der integrierten Schaltung IC versorgt. Mit den generierten Prüfbitmustern und der Kenntnis über die physikalische Prüfpunkt-Anordnung aus dem Lay-out der integrierten Schaltung IC kann dann das Prüfprogramm «PPR» automatisch erzeugt werden. Dieses Prüfprogramm «PPR» ermöglicht einen automatischen Funktionstest der integrierten Schaltung IC. Zellenbausteine sind überwiegend als Standardzellen konstruiert. Standardzellen haben eine einheitliche Höhe und lassen sich leicht aneinanderreihen. Zwischen den Zellenreihen entstehen Verdrahtungskanäle für die Verbindung der Zellenanschlüsse. Jeder Zellenbaustein erhält an seinen Ein-/Ausgängen Prüfpunkte für die Messwerterfassung mit dem Elektronenstrahl-Messgerät 3. Diese Prüfpunkte befinden sich in der Aluminiumebene. Bei einer Zweilagen-Aluminiumverdrahtung befinden sich diese Prüfpunkte in der oberen Verdrahtungsebene. Mit dem Elektronenstrahl-Messgerät 3 können dadurch interne Knoten zerstörungsfrei und ohne Verfälschung durch Kopplungskapazitäten beobachtet werden.

Um die Qualität und die Zuverlässigkeit der integrierten Schaltung IC sicherzustellen, wird die integrierte Schaltung IC statisch, dynamisch und unter verschiedenartigen Belastungen geprüft. Ferner können in der Anlaufphase der Fertigung einer integrierten Schaltung IC systematische Fehler im Maskenentwurf und in der Fertigung aufgedeckt werden. Bei statischen Tests werden die Ausgangssignale nach Ausklingen aller durch den Wechsel der Eingangssignale verursachten Einschwingvorgänge bewertet. Bei dynamischen Tests wird zudem geprüft, ob die Signallaufzeiten innerhalb vorgegebener Grenzwerte liegen und ob die Ausgangssignale die geforderte Flankensteilheit aufweisen. Ein dynamischer Test prüft jeweils einen ausgewählten Signalpfad innerhalb der integrierten Schaltung IC.

Mit Hilfe eines Systems LASAR (D-LASAR User's Guide University Computing Company, Dallas, Texas, 1976) kann die Prüfbitmuster-Generierung einschliesslich Richtig-Simulation der integrierten Schaltung IC automatisch erfolgen. In den Prüfbitmustern sind die anzulegenden binären Eingangswerte und die zugehörigen binären Ausgangs-Sollwerte und die Sollwerte von internen Prüfpunkten beschrieben. Bei dynamischen Tests sind zusätzlich Anweisungen für zeitgenaue Eingabe von Signalfolgen und zeitgenaue Ausgangssignalbewertung angegeben. Ausgehend von den Prüfbitmustern wird das vollständige Prüfprogramm «PPR» prüfautomatenspezifisch in der Prüfsprache des Prüfautomaten generiert. Das Prüfprogramm «PPR» wird in den Objekt-Code des Prüfautomaten übersetzt. Die Prüfbitmuster bestimmen die Prüfschärfe des Prüfprogrammes.

Zur Erstellung des Prüfprogrammes «PPR» steht eine einsatzerprobte, komfortable, problemorientierte Prüfsprache ATLED (Siemens) zur Verfügung.

**Patentansprüche**

1. Verfahren zur Fehlersuche im Innern von VLSI-Schaltungen (IC) mit einer Elektronensonde (1), die an Prüfpunkten im Innern der VLSI-Schaltung (IC) Sekundärelektronen auslöst,

– mit einem Detektor, der über ein Sekundärelektronen-Signal die Ist-Pegel an den Prüfpunkten bestimmt,

– mit einem Logiksimulator (CAD-System VENUS bzw. PRIMUS C) zur Simulation der VLSI-Schaltung (IC) und zur Ermittlung der bei bestimmten Prüfmustern an den Prüfpunkten zu erwartenden Soll-Pegel,

– mit einem Testrechner (4), der eine Ansteuerung (2) für die VLSI-Schaltung (IC) steuert und die Zuordnung von Ist-Pegel und Soll-Pegel veranlasst,

dadurch gekennzeichnet, dass

a) Prüfpunkten im Innern der VLSI-Schaltung (IC) Koordinaten zugeordnet werden und die Prüfpunkte eine Bezeichnung erhalten, und dass die logischen Verknüpfungen der Prüfpunkte untereinander bestimmt werden,

b) die VLSI-Schaltung (IC) über die externen Anschlüsse getestet wird, wobei anhand des sich aus dieser Prüfung ergebenden Fehlerbildes Fehlerpfade bestimmt werden,

c) die Elektronensonde (1) an einem ersten Prüfpunkt eines Fehlerpfades positioniert wird, das entsprechende Prüfmuster angelegt wird und mit Hilfe des Sekundärelektronen-Signals der Ist-Wert am Prüfpunkt bestimmt wird,

d) der Ist-Wert am Prüfpunkt mit dem aus der Simulation der VLSI-Schaltung (IC) mit Hilfe des Logiksimulators (CAD-System VENUS bzw. PRIMUS C) für das gleiche Prüfmuster ermittelten Soll-Wert verglichen wird,

e) der nächste Prüfpunkt im Fehlerpfad in entsprechender Weise getestet wird und dass

f) der Vorgang des Testens an immer neuen Prüfpunkten im Fehlerpfad solange wiederholt wird, bis der Fehlerort lokalisiert wird.

2. Verfahren nach Anspruch 1, gekennzeichnet durch einen Testalgorithmus, der einen Fehlerpfad mit bestimmten Prüfpunkten festlegt.

3. Verfahren nach Anspruch 1 oder 2, dadurch gekennzeichnet, dass die Bewertung der Schaltungszustände an den Prüfpunkten so erfolgt, dass zuerst eine Referenzspannung ermittelt wird, auf welche die ermittelten Spannungswerte bezogen werden.

4. Verfahren nach einem der Ansprüche 1 bis 3, dadurch gekennzeichnet, dass die Elektronensonde (1) automatisch auf einen Prüfpunkt innerhalb der VLSI-Schaltung (IC) positioniert wird.

5. Verfahren nach einem der Ansprüche 1 bis 4, dadurch gekennzeichnet, dass für eine Erkennung dynamischer Fehler zyklische Prüfschleifen online am Testrechner (4) erstellt werden.

6. Verfahren nach einem der Ansprüche 1 bis 5, dadurch gekennzeichnet, dass mehr als ein Prüfmuster innerhalb eines Prüfprogrammes (PPR) zur Anwendung kommen.

7. Verfahren nach einem der Ansprüche 1 bis 6, dadurch gekennzeichnet, dass während des Ablaufs von mehr als einem Prüfmuster die Prüfsonde auf einem einzigen Prüfpunkt verharrt und den jeweiligen Ist-Wert für das jeweilige Prüfmuster an diesem Prüfpunkt ermittelt.

8. Verfahren nach einem der Ansprüche 1 bis 7, dadurch gekennzeichnet, dass während des Ablaufs eines einzigen Prüfmusters die Prüfsonde den jeweiligen Ist-Wert an verschiedenen Prüfpunkten ermittelt.

**Claims**

1. A method of detecting faults in VLSI-circuits (IC) using an electron probe (1) which triggers secondary electrons at test points in the VLSI-circuit (IC)

– with a detector which, via a secondary electron signal, determines the actual level at the test points,

– with a logic simulator (CAD-system VENUS and PRIMUS C) which serve to simulate the VLSI-circuit (IC) and to determine the theoretical level which is likely to occur at the test points with predetermined test patterns,

– with a test computer (4) which controls a drive unit (2) for the VLSI-circuit (IC) and co-ordinates actual value and theoretical value,

characterised in that

a) test points in the VLSI-circuit (IC) are assigned co-ordinates and the test points receive a designation and that the logic-links of the test points one in relation to another are determined,

b) the VLSI-circuit (IC) is tested via the external terminals and fault paths are determined on the basis of the fault picture obtained from this test,

c) the electron probe (1) is positioned at a first test point of a fault path, the appropriate test pattern is applied, and with the aid of the secondary electron signal the actual value at the test point is determined,

d) the actual value at the test point is compared with the theoretical value obtained for the same test pattern from the simulation of the VLSI-circuit (IC) with the assistance of the logic simulator (CAD-system VENUS and PRIMUS C),

e) the next test point in the fault path is tested in a corresponding manner and that

f) the testing procedure is repeated at new test points in the test path until the fault location is localised.

2. A method as claimed in claim 1, characterised by a test algorithm which specifies a test path containing predetermined test points.

3. A method as claimed in claim 1 or 2, characterised in that the evaluation of the circuit states at the test points takes place in such manner that firstly a reference voltage is determined to which the determined voltage values are related.

4. A method as claimed in one of the claims 1 to 3, characterised in that the electron probe (1) is automatically positioned at a test point within the VLSI-circuit (IC).

5. A method as claimed in one of the claims 1 to 4, characterised in that in order to recognise dynamic faults cyclic test loops are set up on-line in the test computer (4).

6. A method as claimed in one of the claims 1 to 5, characterised in that more than one test pattern is used within a test programme (PPR).

7. A method as claimed in one of the claims 1 to 6, characterised in that during the execution of more than one test pattern the test probe remains at one single test point and determines the current actual value for the current test pattern at this test point.

8. A method as claimed in one of the claims 1 to 7, characterised in that during the execution of one single test pattern the test probe determines the current actual value at various test points.

## Revendications

1. Procédé pour rechercher les défauts à l'intérieur de circuits VLSI (IC) à l'aide d'une sonde à électrons (1) qui produit des électrons secondaires en des points de contrôle à l'intérieur du circuit VLSI (IC), comprenant

– un détecteur qui détermine les niveaux effectifs aux points de contrôle au moyen d'un signal d'électrons secondaires,

– un simulateur logique (système CAD VENUS respectivement PRIMUS C) pour la simulation du circuit VLSI (IC) et pour la détermination des niveaux de consigne à attendre aux points de contrôle avec des configurations d'essai déterminées,

– ainsi qu'un calculateur de test (4) qui commande un dispositif d'attaque (2) pour le circuit VLSI (IC) et provoque l'association de niveaux effectifs et de niveaux de consigne,

caractérisé en ce que

a) on attribue des coordonnées et une désignation à des points de contrôle à l'intérieur du circuit VLSI (IC) et on détermine les connexions logiques des points de contrôle entre eux,

b) on teste le circuit VLSI (IC) par les connexions externes et on détermine des trajets défectueux à l'aide de l'image de la défectuosité obtenue par ce test,

c) on place la sonde à électrons (1) à un premier point de contrôle d'un trajet défectueux, auquel on applique des configurations d'essai adéquates et sur lequel on détermine la valeur effective à l'aide du signal d'électrons secondaires,

d) on compare la valeur effective au point de contrôle avec la valeur de consigne déterminée pour la même configuration d'essai par la simulation du circuit VLSI (IC) à l'aide du simulateur logique (système CAD VENUS respectivement PRIMUS C),

e) on teste le point de contrôle suivant sur le trajet défectueux de façon analogue et

f) on répète le processus de test à des points de contrôle sans cesse nouveaux sur le trajet défectueux, jusqu'à ce que le lieu du défaut soit localisé.

2. Procédé selon la revendication 1, caractérisé par l'emploi d'un algorithme de test qui fixe un trajet défectueux avec des points de contrôle déterminés.

3. Procédé selon la revendication 1 ou 2, caractérisé en ce que, pour l'évaluation des états du circuit aux points de contrôle, on détermine d'abord une tension de référence, à laquelle on rapporte les valeurs de tension relevées.

4. Procédé selon une des revendications 1 à 3, caractérisé en ce que la sonde à électrons (1) est positionnée automatiquement sur un point de contrôle à l'intérieur du circuit VLSI (IC).

5. Procédé selon une des revendications 1 à 4, caractérisé en ce que, pour la détection de défauts dynamiques, on établit des boucles d'essai cycliques on-line sur le calculateur de test (4).

6. Procédé selon une des revendications 1 à 5, caractérisé en ce que l'on utilise plus d'une configuration d'essai dans un programme d'essai (PPR).

7. Procédé selon une des revendications 1 à 6, caractérisé en ce que, pendant le déroulement de plus d'une configuration d'essai, la sonde de contrôle reste sur un seul point de contrôle et détermine la valeur effective instantanée pour la configuration concernée en ce point de contrôle.

8. Procédé selon une des revendications 1 à 7, caractérisé en ce que, pendant le déroulement d'une configuration unique, la sonde de contrôle détermine la valeur effective instantanée à différents points de contrôle.

# FIG 1

| RZ | (BS 2000) |
|---|---|
| CAD – System | PRIMUS C ; VENUS |

| PPR | SALI | WELI |
|---|---|---|

Converter

Tester 780
(BS UNIX)

"Master"

EMEG4/R 30
(BS ORG PV)

"Slave"

IC

SEM

IEC-Bus

FIG 2

FIG 3

0104534